# EUROPEAN PATENT APPLICATION

(11) **EP 3 439 006 A1**
(43) Date of publication of application: **06.02.2019**
(21) Application number: 18186918.1
(22) Date of filing: 01.08.2018
(51) Int. Cl.: H01H 13/12

(54) **TOUCHPAD GUIDED BY A LINEAR BEARING WITH BALL BEARINGS**

(30) Priority: 01.08.2017 US 201715665801
(71) Applicant: Visteon Global Technologies, Inc., Van Buren Township, MI 48111-5711 (US)
(72) Inventor: BUCKINGHAM, Thomas, Van Buren Township, MI 48111 (US); PFAU, Douglas Allen, Van Buren Township, MI 48111 (US)
(74) Representative: Dummett Copp LLP

(57) **Abstract**

A button assembly 20 includes a touchpad 22 having an upper surface 26 extending in a generally flat plane and movable between a first position and a second position displaced from the first position in response to the application of a pressing force perpendicular to the upper surface. Additional, smaller pushbuttons 52 may be located adjacent the touchpad. A sub-bezel 58 includes a housing (66) defining a cavity (70) for holding a linear bearing 114 for guiding the touchpad in a linear path perpendicular to the upper surface. The linear bearing includes a plurality of first ball bearings (116) and second ball bearings (118) separated by a first distance (d1) perpendicular to the upper surface. The ball bearings may be sandwiched between a bearing outer member (122) and a bearing inner member (124) which includes an inner top member (126) secured to an inner bottom member (128) with a screw (130). A bearing carrier (168) holds the ball bearings within troughs (136, 142) in the bearing outer member.

## Description

### BACKGROUND

There exist today many different types of input devices for performing operations in an electronic device. Buttons that can be displaced linearly downwardly by being pressed are a common type of input device that is intuitive for users to operate. Touchpad pushbuttons have a relatively large surface area, much larger than that of a typical automotive radio or keyboard sized button, and have traditionally had shortcomings that have prevented them from being linearly displaced without exhibiting wobble or tilting outside of a linear path, particularly when subjected to an off-center pressing force. Larger touchpad pushbuttons are typically controlled and guided by ribs moving in slots, which can still bind and which require gaps that can cause wobble, tilt, rattling, each of which may prevent the assembly from having a quality feel. Other factors, including molding tolerances, process variation, and friction, may each contribute to conventional touchpad pushbuttons having inadequate control of button movement. Therefore, there exists a need for a button assembly that is capable of being linearly displaced in response to a pressing force, but which can also limit tilt and side-to-side wobble movement to achieve a quality feel. In particular, there exists a need for such a button assembly capable of supporting a touchpad having a surface area much larger than that of a typical automotive radio or keyboard sized button and which may have a surface area up to or greater than the surface area of a computer mousepad, or about 20 cm x 23 cm.

### SUMMARY

According to the invention, there is provided a button assembly comprising:
a touchpad comprising a plate having an upper surface and being movable between a first position and a second position displaced from the first position in response to the application of a pressing force perpendicular to said upper surface;
a sub-bezel including a housing defining a top side adjacent said touchpad and defining a cavity extending into the housing from said top side; and
a linear bearing disposed in the cavity of said sub-bezel for guiding the touchpad along a linear path perpendicular to said upper surface between the first position and the second position and for limiting displacement of the touchpad outside of said linear path and including a plurality of first ball bearings and a plurality of second ball bearings separated from said first ball bearings by a first distance perpendicular to said upper surface with said ball bearings being sandwiched between a bearing outer member and a bearing inner member.

The upper surface may extend in a generally flat plane that extends substantially perpendicular to the direction along which the touchpad is movable between the first position and the second position.

The button assembly may further comprise a first switch and a spring member, for example a coil spring, a leaf spring or a dome spring. The spring member may be linked to the touchpad to bias the touchpad to the first position.

The touchpad may further comprise a base portion defining a bottom surface opposite the upper surface of the plate and including a rod extending generally perpendicularly from the bottom surface of the base portion, the bottom surface being engaged with the first switch and the rod transmitting a biasing force from the spring member to bias the touchpad into the first position.

The bearing inner member preferably defines a bore therethrough with the rod extending from the touchpad through this bore to engage the first switch.

At least one of the bearing outer member or the bearing inner member may be provided with a plurality of first troughs extending substantially perpendicularly to the upper surface of the plate. Each of the first troughs may hold and guide a corresponding one of the first ball bearings to guide the touchpad along the linear path.

At least one of the bearing outer member or the bearing inner member may be provided with a plurality of second troughs extending substantially perpendicularly to the upper surface of the plate. Each of the second troughs may hold and guide a corresponding one of the second ball bearings to guide the touchpad along the linear path.

Preferably, both the first and second ball bearings are equidistantly spaced apart from each other around a corresponding circumference of the respective top and bottom ends of the linear bearing. Most preferably the spacings of the first ball bearings are offset circumferentially from those of the second ball bearings, and the number of the first ball bearings is equal to the number of second ball bearings, so that each of the first ball bearings is circumferentially located mid-way between each of the second ball bearings, and *vice versa.*

The bearing outer member may include a tubular side wall extending about an axis.

The bearing outer member may include a first flange with a plurality of first ears each extending outwardly to a first peripheral side, and the sub-bezel may include a plurality of first L-shaped members extending axially and circumferentially and each being configured to hold a corresponding one of the first ears of the bearing outer member.

The first ears of the bearing outer member and the first L-shaped members of the sub-bezel may together function as a bayonet-type fitting to secure the linear bearing within the sub-bezel with relative rotation therebetween to engage the first ears within corresponding ones of the first L-shaped members.

The bearing inner member may include an inner top member that is generally cup-shaped and extending between an open upper end and a lower end of the bearing inner member.

The bearing inner member may include an inner bottom member that is generally cup-shaped and extending between an open lower end and an upper end secured to the lower end of the inner top member.

The inner top member may include an upper lip that extends radially outwardly about the open upper end of the inner upper member for retaining the first ball bearings within the linear bearing.

The open lower end of the inner bottom member may include a bottom lip extending radially outwardly thereabout for retaining the second ball bearings within the linear bearing.

The inner top member of the linear bearing may be provided with a plurality of latching tabs, each of which extends away from the open upper end of the inner upper member to terminate at a trapezoidal end. The trapezoidal end may include a first ledge for engaging a corresponding second ledge on the touchpad and for holding the touchpad onto the linear bearing.

The inner top member of the linear bearing may further include a plurality of second ears each of which extends circumferentially and radially outwardly adjacent the open upper end for each nesting within a corresponding second L-shaped member in the bottom surface of the touchpad.

The lower end of the inner top member may provide a tooling receptacle for receiving a tool to rotate the bearing inner member and to cause the second ears to engage the second L-shaped members with a bayonet-style fitting.

At least one of the bearing outer member or the bearing inner member may be formed from Polyoxymethylene (POM).

The button assembly may further comprise a bearing carrier disposed between the bearing outer member and the bearing inner member for holding the first and second ball bearings and extending between a top end and a bottom end of the bearing carrier. The top and bottom ends may each be provided with a plurality of recesses adjacent each of the ends and each of the recesses may have a U-shape for holding a corresponding one of the first and second ball bearings.

Preferably the recesses of the top end are equidistantly spaced circumferentially and the recesses of the second end are equidistantly spaced circumferentially. Most preferably, the recesses of the top end are circumferentially offset relative to those of the bottom end. For example, each recess of the top end may be circumferentially located mid-way between a corresponding pair of recesses of the bottom end.

There may be at least three ball bearings in each of the first and second sets of ball bearings and in a preferred embodiment of the invention, there are four in each set.

The button assembly may comprise, within the cavity of the sub-bezel, a generally cylindrical collar provided with an internal thread. The bearing outer member may then have an external thread thereabout for engaging the internal thread of the collar to secure the linear bearing within the cavity of the sub-bezel.

Also according to the invention, there is provided a button assembly comprising:
a touchpad having an upper surface and being movable between a first position and a second position displaced from said first position in response to the application of a pressing force perpendicular to said upper surface;
a linear bearing for guiding the touchpad along a linear path perpendicular to said upper surface between the first position and the second position and for limiting displacement of the touchpad outside of the linear path and including a plurality of first ball bearings and a plurality of second ball bearings separated from said first ball bearings by a first distance perpendicular to said upper surface with said first and second ball bearings being sandwiched between a bearing outer member and a bearing inner member;
wherein
the bearing inner member including an inner top member secured to an inner bottom member;
the bearing inner member including an inner top member being generally cup-shaped and extending between a lower end and an open upper end; and
the inner bottom member being generally cup-shaped and extending between an open lower end and an upper end secured to said lower end of the inner top member.

The inner top member may be provided with an upper lip extending radially outwardly about the open upper end of the inner top member for retaining the first ball bearings within the linear bearing.

The button assembly may comprise, within inner bottom member a bottom lip that extends radially outwardly about the open lower end of the inner bottom member for retaining the second ball bearings within the linear bearing.

### BRIEF DESCRIPTION OF THE DRAWINGS

The invention will now be further described, by way of example only, and with reference to the following drawings, in which like numerals refer to like items, and in which:
FIG. 1 is a side cut-away view of a button assembly of the prior art;
FIG. 2 is a top cut-away view of a button assembly of the prior art;
FIG. 3 is an exploded view of an of a button assembly in a preferred embodiment of the invention;
FIG. 4 is a cut-away perspective view of the assembled button assembly of FIG. 3;
FIG. 5 is a perspective view of the button assembly of FIG. 4;
FIG. 6 is a side sectional view of the button assembly of FIG. 3 in a first position;
FIG. 7 is a is a side sectional view of the button assembly of FIG. 3 in a second position;
FIG. 8 is a top view of a sub-bezel of the button assembly of FIG. 3;
FIG. 9 is a sectional side view of a linear bearing of the button assembly of FIG. 3;
FIG. 10 is a perspective view of an inner top member of the linear bearing of FIG. 9;
FIG. 11 is a perspective view of a bearing outer member of the linear bearing of FIG. 9;
FIG. 12 is a perspective view of a bearing carrier of the linear bearing of FIG. 9;
FIG. 13 is a schematic sectional side view of the button assembly of the example implementation;
FIG. 14 is a top view of an alternative embodiment of a linear bearing in accordance with the present disclosure;
FIG. 15 is a lower perspective view of a sub-bezel of another alternative embodiment in accordance with the present disclosure; and
FIG. 16 is a side view of a linear bearing in accordance with the alternative embodiment of FIG. 15.

### DETAILED DESCRIPTION

The invention is described more fully hereinafter with references to the accompanying drawings, in which exemplary embodiments of the invention are shown. This invention may, however, be embodied in many different forms and should not be construed as limited to the embodiments set forth herein. Rather, these exemplary embodiments are provided so that this disclosure is thorough, and will fully convey the scope of the invention to those skilled in the art. It will be understood that for the purposes of this disclosure, "at least one of each" will be interpreted to mean any combination the enumerated elements following the respective language, including combination of multiples of the enumerated elements. For example, "at least one of X, Y, and Z" will be construed to mean X only, Y only, Z only, or any combination of two or more items X, Y, and Z (e.g., XYZ, XZ, YZ, X). Throughout the drawings and the detailed description, unless otherwise described, the same drawing reference numerals are understood to refer to the same elements, features, and structures. The relative size and depiction of these elements may be exaggerated for clarity, illustration, and convenience. Unless otherwise stated, any reference to moving between two or more different positions should be construed as including moving in either direction from one position to another position or *vice-versa.*

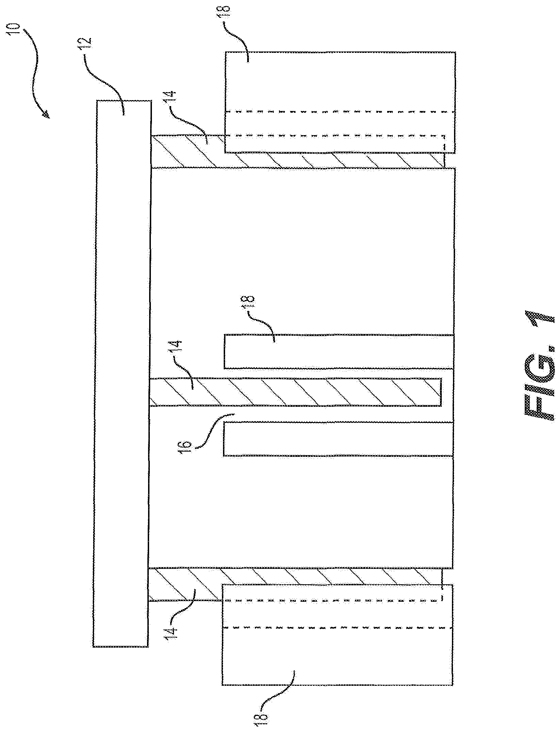

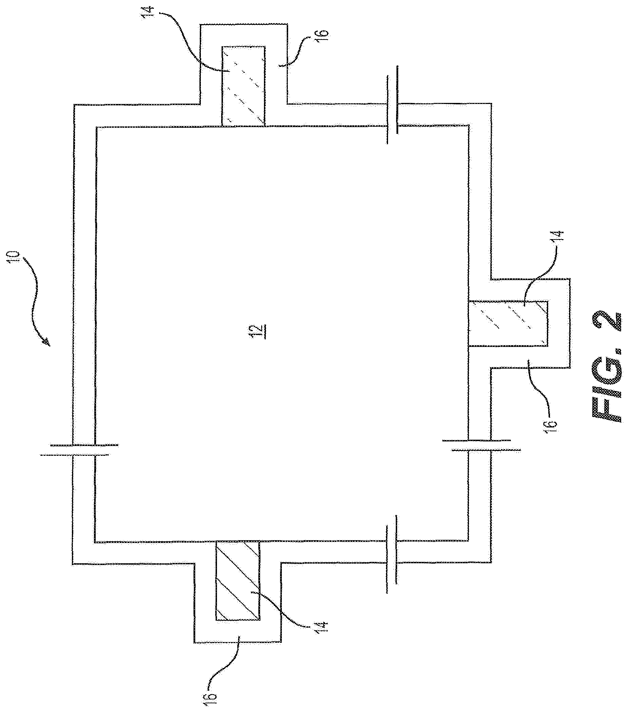

A design of button **10** according to the prior art is shown in FIGS. 1 and 2, which includes a button pad **12** extending in a generally flat plane with a plurality of guide ribs **14** extending perpendicularly therefrom and disposed within guide slots **16** of a stationary structure **18** located below the button pad **12.** As best shown in FIG. 2, small gaps, which may be approximately 0.03 mm on each side, are required around each of the guide ribs **14** within the corresponding guide slots **16** to allow the button pad **12** to be displaced linearly while minimizing wobble in each direction except for the desired linear direction perpendicular to the generally flat plane of the button pad **12.**

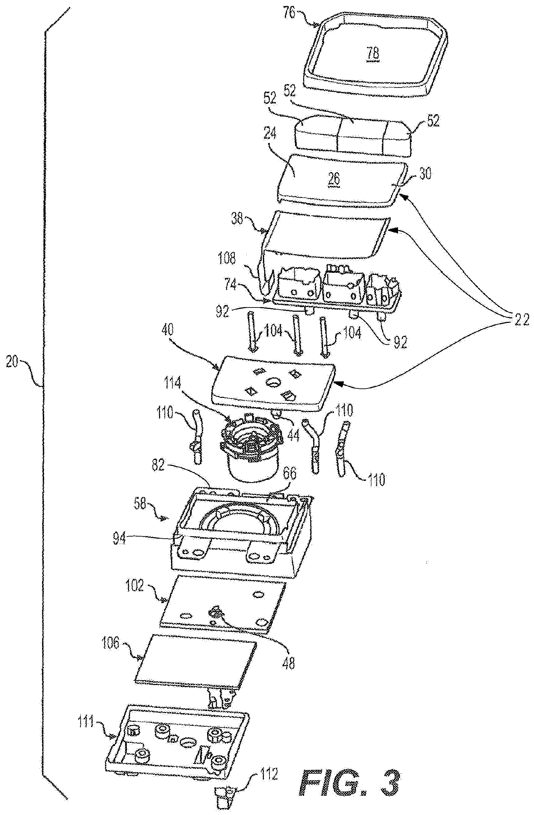

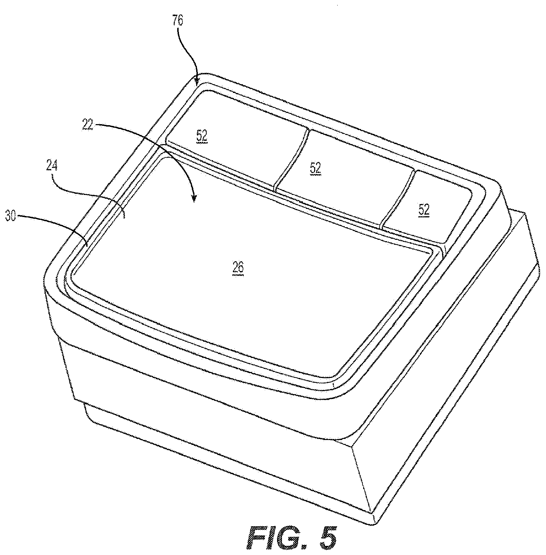

Referring to the Figures, wherein like numerals indicate corresponding parts throughout the several views, a button assembly **20** is disclosed. As best shown in FIGS. 3-8, the button assembly **20** comprises a touchpad **22** including a plate **24** having an upper surface **26** extending in a generally flat plane. The touchpad **22** may be responsive to one or more physical touches, similar to the function of the touchscreen of a smartphone or the trackpad of a laptop computer. The touchpad **22** may alternatively function as a basic pushbutton, being operable only by being physically depressed. As best shown in FIG. 5, the upper surface **26** of the touchpad **22** may have a generally rectangular shape for accepting a two-dimensional touch-based input. The upper surface **26** of the touchpad **22** may also include a raised peripheral edge **30** to allow a user to feel the edges when using it for touch-based input.

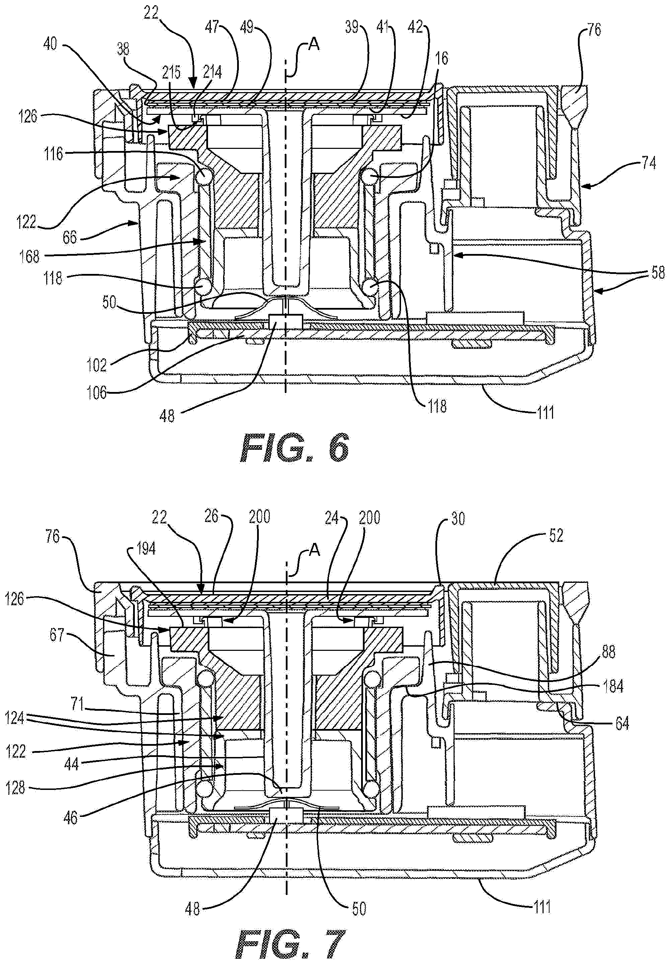

As best shown in FIGS. 6 and 7, the touchpad **22** may be movable between a first position and a second position displaced from the first position in response to the application of a pressing force perpendicular to the upper surface **26.** A pressing force above a predetermined actuation force may be required to cause the touchpad **22** to move from the first position. The touchpad **22** may also include an electrically responsive layer **38** on a lower surface **39** of the plate **24** opposite the upper surface **26** for converting a touch-based input, such as by a person gliding their finger over the upper surface **26,** into an electrical signal. The touchpad **22** may include beneath the electrically responsive layer **38** a base portion **40** having an upper surface **41** of which faces towards the electrically responsive layer **38** and a bottom surface **42** of which faces in an opposite direction to the upper surface **26** of the touchpad **22.** The opposite surfaces **41, 42** of the electrically responsive layer **38** may be bonded by corresponding adhesive layers **47, 49** to the adjacent lower surface **39** of the plate **24** and upper surface **41** of the base portion **40.**

The base portion **40** may also include a rod **44,** which may have a generally cylindrical shape, extending generally perpendicularly from a central area of the bottom surface **42** to an end **46** of the rod for engaging a first switch **48.** As shown in FIGS. 6 and 7, the end **46** of the rod may be coupled to the switch **48** by an intervening spring, for example a conical coil spring or, as illustrated, a metallic dome spring **50,** which becomes compressed until the switch **48** is activated in response to the touchpad **22** being moved to the second position and which therefore also biases the touchpad **22** away from the switch **48** to the first position. In other words, the button assembly **20** may be responsive to a light or gliding touch on the touchpad **22,** and may also be responsive to being more firmly pressed to displace the touchpad **22** from its first position downward into its second position. Such a firmer pressing may correspond, for example, to a selection command or a function similar to a mouse click in a more traditional computer interface.

As best shown in FIG. 5, the button assembly **20** may also include one or more pushbuttons **52** adjacent the touchpad **22,** with each being pressable to activate a corresponding electrical switch. In the exemplary embodiment shown in the figures, there may be three pushbuttons **52.** Each of the pushbuttons **52** may include a corresponding first, second and third indicia, which may be different between each of the pushbuttons **52** to denote the respective function associated therewith.

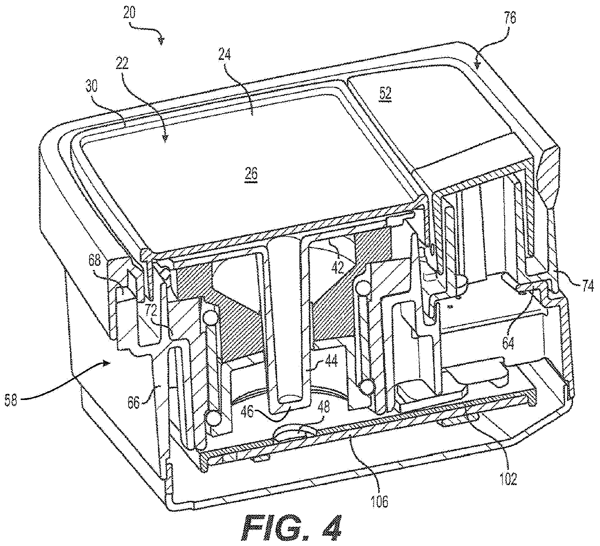

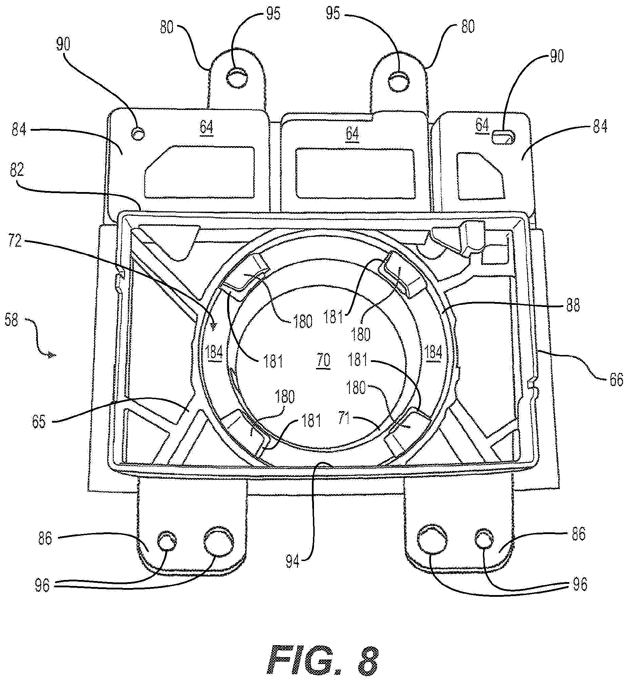

As best shown in FIGS. 3-5, and FIG. 8, the button assembly **20** includes a sub-bezel **58,** which may include one or more structures such as mounting tabs for securing the button assembly **20** to a larger assembly such as, for example, a vehicle body (not shown). As shown in FIGS. 4 and 8, the sub-bezel **58** may include a generally rectangular housing **66** that supports the touchpad **22.** The sub-bezel also includes a flat ledge **64** attached to one side of the generally rectangular housing **66.** The flat ledge **64,** when assembled to the generally rectangular housing **66,** is laterally adjacent to the touchpad **22.** The sub-bezel **58** extends around a cavity 70 having a generally stepped cylindrical shape extending axially within the generally rectangular housing **66.** A top end **68** of the generally rectangular housing **66** terminates at a rectangular rim **67.** A lower end of the cavity **70** is defined by a cylindrical wall **71.** An upper end of the cavity **70** may also terminate at a throat **72** longitudinally adjacent the top end **68** of the housing **66.** The generally rectangular housing **66** may also support an inner frame **65** that includes a collar **88** that has a generally cylindrical shape coaxial with and having a larger diameter than that of the cavity **70.**

A substantially annular and planar seat **184** in the throat **72** of the sub-bezel **58** extends radially between the collar **88** of the cavity **70** and the cylindrical wall **71** of the cavity **70.**

As shown in FIGS. 3 and 4, the button assembly **20** may include a button carrier **74** disposed upon the flat ledge **64** of the sub-bezel **58** for holding and guiding the pushbuttons **52** in a linear path perpendicular to the upper surface **26** of the touchpad **22.** The button assembly **20** may also include a top bezel **76** having a generally ring shape and defining a generally rectangular opening **78** for surrounding the touchpad **22.** As shown in FIGS. 3, 8 and 15, the sub-bezel **58** may include one or more first catches or tabs **80** extending outwardly from a first edge **82** and generally parallel to the upper surface **26** of the touchpad **22,** for securing the button assembly **20** to the vehicle body, for example by means of one or more locating holes **95.** The sub-bezel **58** may also include a plurality of first flat portions **84** extending outwardly from the first edge **82** and generally parallel to the upper surface **26** of the touchpad **22,** which may each provide a first locating hole **90** for receiving a corresponding first locating pin **92** of the button carrier **74** for locating and securing the button carrier **74** thereupon. The sub-bezel **58** may further include one or more second catches or tabs **86** extending outwardly from a second edge **94** opposite the first edge **82** and generally parallel to the upper surface **26** of the touchpad **22,** for securing the button assembly **20** to the vehicle body, for example by means of one or more locating holes **96.**

A switch mat **102** of resilient material may be disposed adjacent the sub-bezel **58** parallel to and opposite from the touchpad **22** which may be elastically deformed in response to the application of force on any of the pushbuttons **52** and for providing an upward biasing force thereto. An actuator post **104** may extend between each of the pushbuttons **52** and a corresponding switch portion of the switch matt **102.** The switch matt **102** may also include the dome spring **50** of the first switch **48** for biasing the touchpad **22** upward to its first position. A circuit board **106** may be disposed adjacent and generally parallel to the switch matt **102** opposite the sub-bezel **58.** The circuit board **106** may be in electrical communication with the electrically responsive layer **38** with a ribbon cable **108** extending therebetween for receiving the touch-based input applied to the touchpad **22.** The circuit board **106** may include a plurality of LED lights, which may shine through corresponding light pipes **110** that extend through the sub-bezel **58,** to illuminate each of the pushbuttons **52.** The circuit board **106** may also include all or part of the electrical switches corresponding to the pushbuttons **52** and/or an electrical switch activated by the dome spring **50** of the first switch **48** in response to the touchpad **22** being pressed and displaced to the second position. It should be appreciated that the circuit board **106** may also be responsive to the touchpad **22** being displaced a variable amount between the first and second positions such as, for example, using a linear potentiometer to generate a corresponding variable electrical signal. A lower cover **111** may be disposed adjacent and generally parallel to the circuit board **106** opposite the switch matt **102,** and may be secured with a plurality of screws extending therethrough for engaging the sub-bezel **58** and for holding the circuit board **106** and the switch matt **102** with the sub-bezel **58.** As shown in FIG. 3, a grounding lug **112** may be attached thereto for providing an electrical grounding connection.

The button assembly **20** may include a linear bearing **114** disposed in the cavity **70** of the sub-bezel **58** for guiding the touchpad **22** in a linear path perpendicular to the upper surface **26** between the first position and the second position and for limiting displacement of the touchpad **22** outside of the linear path. The linear bearing **114** includes a plurality of first ball bearings **116** and a plurality of second ball bearings **118** separated from the first ball bearings **116** by a first distance **d1** perpendicular to the upper surface **26.** As shown in the figures, the button assembly **20** may include four of the first ball bearings **116** and four of the second ball bearings **118,** however, the button assembly **20** could include any number of ball bearings **116, 118,** and the number of first ball bearings **116** could be the same as or different from the number of second ball bearings **118.** The ball bearings **116,118** may be sandwiched between a bearing outer member **122,** which may be formed of Polyoxymethylene (POM), and a bearing inner member **124** which may also be formed of Polyoxymethylene (POM), and which may include an inner top member **126** secured to an inner bottom member **128** with one or more fasteners **130,** which may be screws. It should be appreciated that other types of fasteners **130** may be used including, for example, one or more rivets, clips, welds, adhesives, etc..

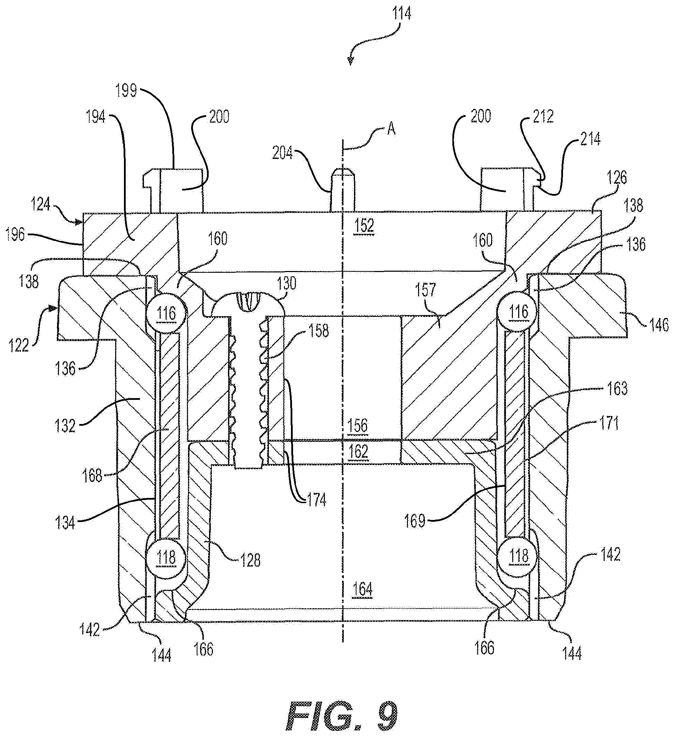

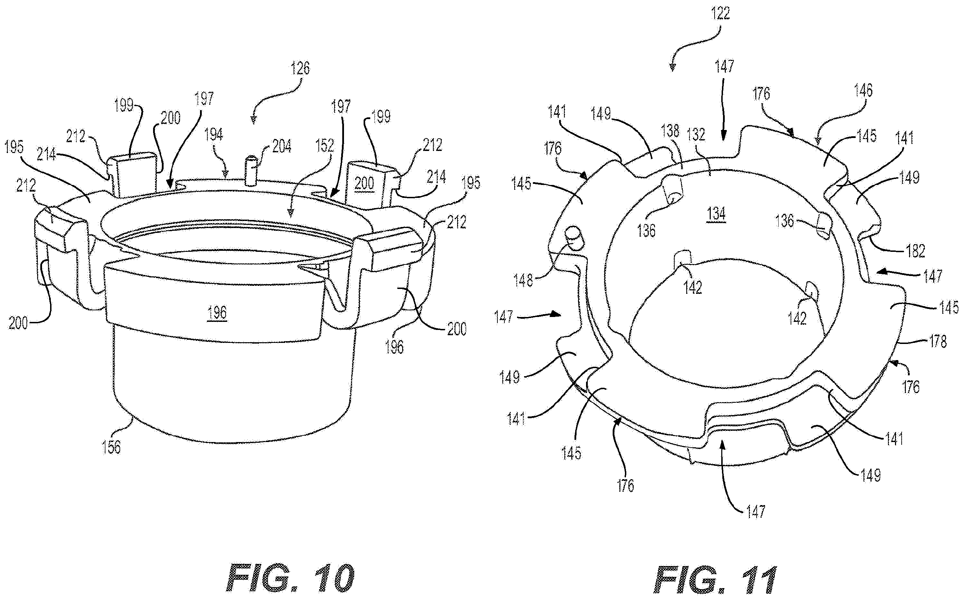

As shown in FIGS. 9 and 11, the bearing outer member **122** may include a tubular side wall **132** extending about an axis **A** and defining a generally cylindrical inner surface **134** with a plurality of first troughs **136** extending axially from a first end **138** and spaced at regular intervals circumferentially thereabout with each of the first toughs receiving and guiding a corresponding one of the first ball bearings **116** parallel to the axis **A.** The tubular side wall **132** may also include a plurality of second troughs **142** extending from a second end **144** opposite the first end **138** and spaced at regular intervals circumferentially thereabout with each of the second troughs **142** receiving and guiding a corresponding one of the second ball bearings **118** parallel to the axis **A.** A first flange **146** may extend radially outwardly about the first end **138** of the tubular side wall **132.** A third locating pin **148** may extend axially from the first flange for engaging a corresponding indentation in the inner top member **126** (not shown in the figures).

As best shown in FIGS. 9 and 10, the inner top member **126** may be generally cup-shaped, extending between an open upper end **152** and a lower end **156.** The lower end **156** has an inwardly projecting annular flange **157** in which may be provided one or more first holes **158** extending therethrough for receiving the fastener **130** for securing the inner top member **126** together with the inner bottom member **128.** The inner top member **126** may be provided with an upper lip **160** extending radially outwardly for retaining the first ball bearings **116** and may also be provided with a third locating hole (not shown in the figures) for receiving the third locating pin **148** of the bearing outer member **122** for limiting relative rotation therebetween. The inner bottom member **128** may likewise be generally cup-shaped and extending between an upper end **162** that may be provided with an inwardly projecting annular flange **163** for engaging the fastener **130** and an open lower end **164** with a bottom lip **166** extending radially outwardly thereabout for retaining the second ball bearings **118.** The inwardly projecting annular flanges of the lower end **156** of the inner top member **126** and the upper end **162** of the inner bottom member **128** are in contact along abutting surfaces. Radially inner surfaces of the inwardly projecting annular flanges together define a bore **174** therethrough along the axis **A.**

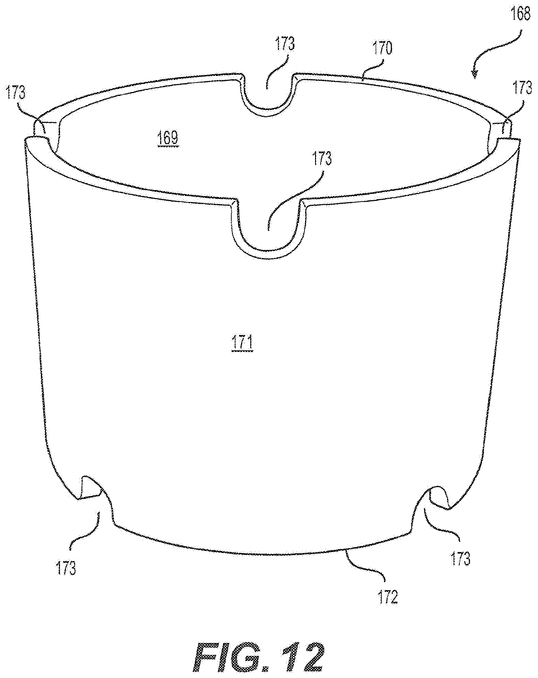

As shown in FIGS. 9 and 12, a bearing carrier **168** may be disposed between the bearing outer member **122** and the bearing inner member **124** for holding the ball bearings **116, 118.** The bearing carrier **168** may have a generally tubular shape with a substantially cylindrical inner surface **169** and a substantially cylindrical outer surface **171** extending between a top end **170** and a bottom end **172.** The top and bottom ends **170, 172** of the bearing carrier **168** may be provided with a plurality of cutouts or recesses **173,** with each of the recesses **173** having a U-shape for holding a corresponding one of the ball bearings **116, 118.** As shown in FIG. 12, each of the first ball bearings **116** is circumferentially offset from each of the second ball bearings **118,** so that each of the first ball bearings is circumferentially mid-way between each of the second ball bearings when viewed along an axial direction. When there are four of each of the first and second sets of ball bearings, as illustrated, the result is each set is offset circumferentially from the other set by 90°.

A particular advantage of having two sets of four ball bearings **116, 118** at each of the top and bottom ends **170, 172** of the bearing carrier **168,** the ball bearings in each set being spaced apart by 90°, is that directly opposite ball bearings form two pairs, the two pair of ball bearings constraining the lateral movement of the bearing inner member **124** with respect to the bearing outer member **122** along two respective orthogonal directions. A further advantage is obtained by the 45° rotation between the top pairs of ball bearing and the bottom pairs of ball bearings, in that each set of ball bearing provides maximum stability along different directions to the other set of ball bearings.

As best shown in FIG. 9, when assembled in the linear bearing **114,** each of the inner top member **126** and the inner bottom member **128** together may be at least partially disposed within the bearing outer member **122** and may together define the bore **174** therethrough along the axis **A,** with the rod **44** extending from the touchpad **22** through the bore **174** to engage the first switch **48** for biasing the touchpad **22** to the first position and providing the predetermined actuation force.

As shown in FIG. 11, the first flange **146** of the bearing outer member **122** may be circumferentially segmented into a plurality of segments, referred to herein as first ears **176.** In this example there are four such ears **176,** each of the first ears extending circumferentially between adjacent gaps **147** and radially outwardly to a first peripheral side **178** having a generally constant diameter from the axis **A** for nesting within the throat **72** of the sub-bezel **58.**

Each of the first ears **176,** has a main portion **145** and a portion **149** having a reduced thickness in an axial direction as compared with the thickness of the main portion **145.** A step **141** in thickness is provided on an upper side of each ear, between the main and reduced thickness portions **145, 149,** this step extending in a radial direction away from the tubular side wall **132.** The reduced thickness portion faces circumferentially away from the step **141** towards one of the adjacent gaps **147.**

As shown in FIG. 8 the throat **72** of the sub-bezel **58** may include a plurality of first L-shaped members **180,** in this example four, extending axially above the seat **184** and circumferentially inwards from the collar **88.** Each of the first L-shaped members **180** is sized and positioned to be received in a corresponding one of the gaps **147** between the first ears **176,** and has a circumferentially directed opening **181** that is configured to receive and hold a corresponding one of the reduced thickness portions **139** of one of the first ears **176** of the bearing outer member **122.** As such, the first ears **176** of the bearing outer member **122** and the first L-shaped members **180** within the throat **72** of the sub-bezel **58** may together function as a bayonet-type fitting to secure the linear bearing **114** within the sub-bezel **58** using a twisting motion to engage the first ears **176** within corresponding ones of the first L-shaped members **180.** Furthermore, and as shown in FIGS. 8 and 11, the first ears **176** may provide a planar surface **182** that faces in a direction away from the touchpad **22** for engaging the planar seat **184** in the throat **72** of the sub-bezel **58.**

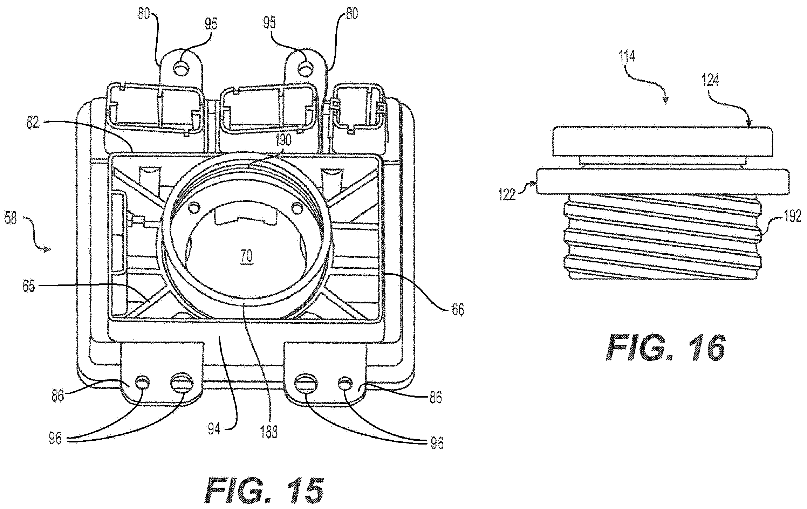

In an alternative embodiment, and as shown in FIGS. 15 and 16, the cavity **70** of the sub-bezel **58** may include a generally cylindrical collar **188** that has an internal thread **190** and the bearing outer member **122** may have an external thread **192** thereabouts for engaging the internal thread **190** to secure the linear bearing **114** within the cavity **70** of the sub-bezel **58.**

As best shown in FIGS. 9 and 10, the inner top member **126** of the linear bearing 114 may have a second flange **194** that extends radially outwardly from the upper lip **160** adjacent the open upper end **152** of the inner top member **126.** The second flange **194** is circumferentially segmented into a plurality of segments **195,** in this example four, each segment extending circumferentially between adjacent gaps **197** and radially outwardly to a second peripheral side **196** having a generally constant diameter from the axis **A.** A plurality of latching tabs **200,** in this example four latching tabs, are each situated in a corresponding one of the gaps **197.** Each latching tab **200** extends axially beyond the second flange **194** away from the open upper end **152.** Each latching tab **200** terminates at a trapezoidal end **212** including a first ledge **214,** which, as shown in FIGS. 6 and 7, engages with a corresponding second ledge **215** of a catch **216.** The catch **216** extends away from the bottom surface **42** of the base portion **40** of the touchpad **22** towards the open upper end **152** of the inner top member **126,** and the second ledge **215** faces in an opposite direction to the first ledge **214.** The four resilient tabs **200** and four corresponding catches **216** resiliently snap into engagement with each other such that the first and second ledges come into abutting contact with each other when the base portion **40** of the touchpad **22** is pressed up against the inner top member **126** during assembly of the button assembly **20.** This secures the touchpad **22** radially with respect to the movement axis **A.** At the same time, an upper surface **199** of the trapezoidal ends **212** is pulled by the engagement up against the bottom surface **42** of the base portion **40** of the touchpad **22** to secure the touchpad in an axial direction with respect to the bearing inner member **124.**

In this way, the touchpad **22** is secured to the linear bearing **114.** The second flange **194** may also include one or more fourth locating pins **204** extending axially upwardly away from the open upper end **152** for engaging corresponding locating holes (not shown) in the bottom surface **42** of the base portion **40** of the touchpad **22** to ensure that that the latching tabs **200** are correctly oriented with respect to the catches **216.**

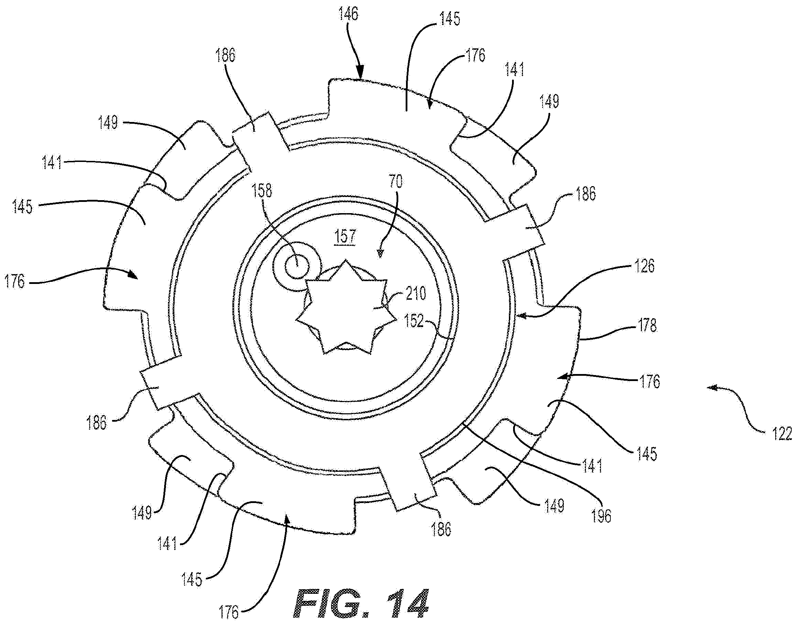

In an alternative embodiment, as shown in FIG. 14, instead of latching tabs **200,** the inner top member **126** of the linear bearing **114** may include a plurality of second lobes or ears **186.** The second ears **186,** of which there are four in this example, are only shown schematically in FIG. 14, but may have a similar shape to the first ears **176,** but inverted in the axial direction so that these each extend circumferentially and radially outwardly adjacent the open upper end **152** the inner top member **126** to engage within corresponding second L-shaped members (not shown, but of a similar shape and axially inverted to the first L-shaped members **180**) extending axially and circumferentially in the bottom surface **42** of the base portion **40** of the touchpad **22.**

In this embodiment, so that this engagement with the base portion **40** may be made, the lower end **156** of the inner top member **126** may be provided with a tooling receptacle **210,** which may, for example, have a star shape, for receiving a tool (not shown) to rotate the bearing inner member **124** to cause the second ears **186** to engage the second L-shaped members with a bayonet-style fitting. This tool would be engaged with the tooling receptacle **210** from beneath the linear bearing **114,** before assembly of the switch mat **102,** circuit board **106** and, lower cover **111.** In this example, the tool would have an axially extending recess to accommodate the end **46** of the rod **44.**

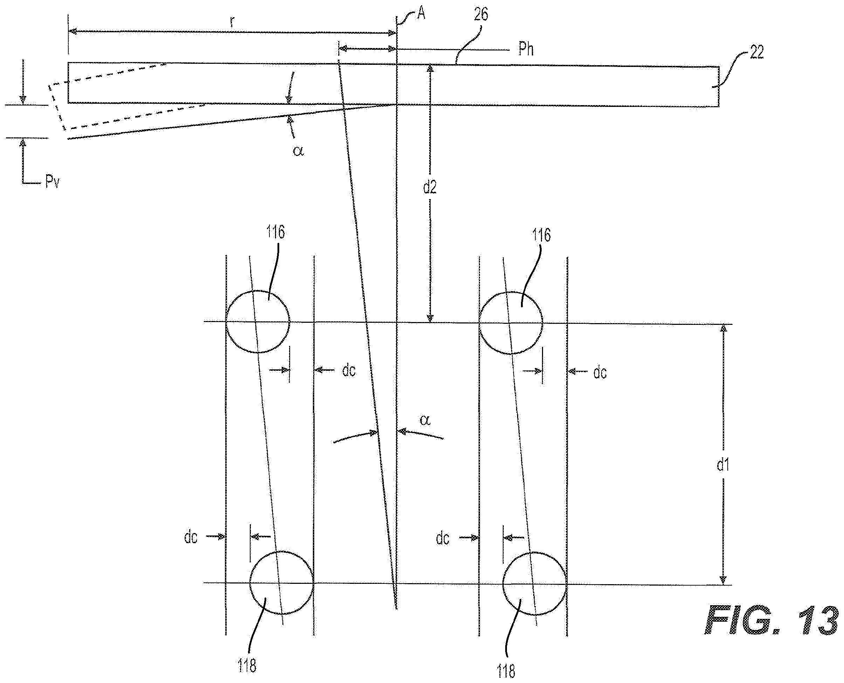

As shown schematically in FIG. 13, the button assembly **20** of the present disclosure may include a clearance distance **dc** that the ball bearings **116, 118** are free to move perpendicular to the axis **A.** The button assembly **20** may be provided with a first distance **d1** between the respective planes of the first and second ball bearings **116, 118** of 11.25 mm and a second distance **d2** between the first ball bearings **116** and the upper surface **26** of the touchpad **22** of about 8.5 mm, and may allow a touchpad **22** to tilt a maximum tilt angle **α** of 0.713°, allowing for a touchpad **22** to have a vertical play **Pv** of 0.49 mm parallel to the axis **A** at the center of a side edge a radial distance **r** of 40 mm away from the axis **A.** It also allows for the touchpad **22** to have a horizontal play **Ph** of 0.25 mm perpendicular to the axis **A.** At a corner of the touchpad **22,** which is a radial distance **r** of 48 mm away from the axis **A,** the vertical play **Pv** is 0.59 mm parallel to the axis **A.** Increasing the first distance **d1** to 18.75 mm, while keeping the other dimensions constant, reduces the maximum tilt angle **α** to 0.428°, allowing the same touchpad **22** to have a vertical play **Pv** of 0.299 mm at the center of a side edge a radial distance **r** of 40 mm away from the axis **A** and a horizontal play **Ph** of 0.20 mm. The vertical play **Pv** and horizontal play **Ph** dimensions may also be known as "vertical wobble" and "horizontal wobble" respectively.

The person skilled in the art will appreciate that many modifications and variations of the present invention are possible in light of the above teachings and may be practiced otherwise than as specifically described while remaining within the scope of the appended claims.

## Claims

1. A button assembly comprising:
a touchpad comprising a plate having an upper surface and being movable between a first position and a second position displaced from the first position in response to the application of a pressing force perpendicular to said upper surface;
a sub-bezel including a housing defining a top side adjacent said touchpad and defining a cavity extending into the housing from said top side; and
a linear bearing disposed in the cavity of said sub-bezel for guiding the touchpad along a linear path perpendicular to said upper surface between the first position and the second position and for limiting displacement of the touchpad outside of said linear path and including a plurality of first ball bearings and a plurality of second ball bearings separated from said first ball bearings by a first distance perpendicular to said upper surface with said ball bearings being sandwiched between a bearing outer member and a bearing inner member.

2. The button assembly according to Claim 1, the button assembly further comprising a first switch and a spring member and the touchpad further comprising a base portion defining a bottom surface opposite said upper surface and including a rod extending generally perpendicularly from said bottom surface, the bottom surface being engaged with the first switch and the rod transmitting a biasing force from the spring member to bias the touchpad into the first position.

3. The button assembly according to Claim 1 or Claim 2, wherein the bearing inner member defines a bore therethrough with the rod extending from the touchpad through said bore to engage the first switch.

4. The button assembly according to any preceding claim, wherein at least one of the bearing outer member or the bearing inner member defines a plurality of first troughs extending perpendicular to said upper surface and with each of said first troughs holding and guiding a corresponding one of said first ball bearings to guide the touchpad along said linear path.

5. The button assembly according to Claim 4 wherein at least one of said bearing outer member or said bearing inner member defines a plurality of second troughs extending perpendicular to said upper surface and with each of said second troughs holding and guiding a corresponding one of said second ball bearings to guide said touchpad along said linear path.

6. The button assembly according to any preceding claim, wherein the bearing outer member includes a tubular side wall extending about an axis.

7. The button assembly according to any preceding claim, wherein the bearing outer member includes a first flange with a plurality of first ears each extending outwardly to a first peripheral side, and wherein the sub-bezel includes a plurality of first L-shaped members extending axially and circumferentially and each configured to hold a corresponding one of said first ears of the bearing outer member; and
wherein said first ears of the bearing outer member and said first L-shaped members of the sub-bezel together function as a bayonet-type fitting to secure the linear bearing within the sub-bezel with relative rotation therebetween to engage said first ears within corresponding ones of said first L-shaped members.

8. The button assembly according to any preceding claim, wherein the bearing inner member includes an inner top member being generally cup-shaped and extending between an open upper end and a lower end; and
wherein the bearing inner member includes an inner bottom member being generally cup-shaped and extending between an open lower end and an upper end secured to the lower end of the inner top member.

9. The button assembly according to Claim 8, wherein the inner top member includes an upper lip extending radially outwardly about said open upper end for retaining said first ball bearings within the linear bearing.

10. The button assembly according to Claim 8 or Claim 9, wherein the open lower end of the inner bottom member includes a bottom lip extending radially outwardly thereabout for retaining said second ball bearings within the linear bearing.

11. The button assembly according to any one of Claims 8 to 10, wherein the inner top member of the linear bearing defines a plurality of latching tabs extending away from said open upper end to terminate at a trapezoidal end, said trapezoidal end including a first ledge for engaging a corresponding second ledge on the touchpad and for holding the touchpad onto the linear bearing.

12. The button assembly according to any one of Claims 8 to 10, when dependent from Claim 2 wherein the inner top member of the linear bearing further includes a plurality of second ears each extending circumferentially and radially outwardly adjacent said open upper end for each nesting within a corresponding second L-shaped member in the bottom surface of the touchpad; and
said lower end of the inner top member provides a tooling receptacle for receiving a tool to rotate the bearing inner member and to cause said second ears to engage said second L-shaped members with a bayonet-style fitting.

13. The button assembly according to any preceding claim, the button assembly further comprising a bearing carrier disposed between the bearing outer member and the bearing inner member for holding said first and second ball bearings and extending between a top end and a bottom end of the bearing carrier, said top and bottom ends defining a plurality of recesses adjacent each of said ends and each of said recesses having a U-shape for holding a corresponding one of said first and second ball bearings.

14. The button assembly according to any preceding claim, wherein within said cavity of said sub-bezel a generally cylindrical collar defines an internal thread and the bearing outer member defines an external thread thereabout for engaging said internal thread to secure the linear bearing within said cavity of the sub-bezel.

15. A button assembly comprising:
a touchpad having an upper surface and being movable between a first position and a second position displaced from said first position in response to the application of a pressing force perpendicular to said upper surface;
a linear bearing for guiding the touchpad along a linear path perpendicular to said upper surface between the first position and the second position and for limiting displacement of the touchpad outside of the linear path and including a plurality of first ball bearings and a plurality of second ball bearings separated from said first ball bearings by a first distance perpendicular to said upper surface with said first and second ball bearings being sandwiched between a bearing outer member and a bearing inner member;
wherein
the bearing inner member including an inner top member secured to an inner bottom member;
the bearing inner member including an inner top member being generally cup-shaped and extending between a lower end and an open upper end; and
the inner bottom member being generally cup-shaped and extending between an open lower end and an upper end secured to said lower end of the inner top member.
